# EUROPEAN PATENT APPLICATION

(11) **EP 4 365 937 A1**
(43) Date of publication of application: **08.05.2024**
(21) Application number: 22831972.9
(22) Date of filing: 27.06.2022
(51) Int. Cl.: H01L 23/31, H01L 23/498, H01L 23/58, H01L 23/60

(54) **QUANTUM DEVICE AND PREPARATION METHOD THEREFOR, AND ELECTRONIC DEVICE**

(30) Priority: 28.06.2021 CN 202110718555; 28.06.2021 CN 202121464017 U
(71) Applicant: Origin Quantum Computing Technology (Hefei) Co., Ltd, Hefei, Anhui 230088 (CN)
(72) Inventor: YANG, Hui, Hefei, Anhui 230088 (CN); LI, Ye, Hefei, Anhui 230088 (CN)
(74) Representative: advotec.
(86) International application number: PCT/CN2022/101569
(87) International publication number: WO 2023/274158

(57) **Abstract**

A quantum device, a manufacturing method thereof, and an electronic device are provided. The quantum device includes: a quantum chip, wherein a signal transmission element and a connecting segment electrically connected to the signal transmission element are formed on the quantum chip; a package substrate, wherein a lead-out segment and a lead-out signal line configured to be electrically connected to a signal connector are formed on the package substrate, and the lead-out signal line is electrically connected to the lead-out segment; and a ball grid array configured to electrically connect the connecting segment to the lead-out segment corresponding to each other. The ball grid array electrically connects the connecting segment to the lead-out segment whose signal transmission properties correspond to each other, thereby realizing electrically connecting the quantum chip to the transmission line, and leading out the connecting segment to an external signal connector. In the present disclosure, the ball grid array does not produce complex field effect, and the electrical connection between the connecting segment and the lead-out segment corresponding to each other by the ball grid array can prevent interference introduced by aluminum wire bonding.

## Description

The present application claims priority to Chinese Patent Application No. 202110718555.X, entitled "Quantum Device, Manufacturing Method Thereof, And Electronic Device" and filed to the China Patent Office on June 28, 2021, and claims priority to Chinese Patent Application No. 202121464017.4, entitled "Quantum Device And Electronic Device" and filed to the China Patent Office on June 28, 2021, the entire contents of both of which are incorporated herein by reference.

### TECHNICAL FIELD

The present disclosure relates to the field of quantum information, especially the technical field of quantum computing, and in particular, to a quantum device, a manufacturing method thereof, and an electronic device.

### BACKGROUND

A quantum chip requires a stable operating environment. Therefore, in order to reduce an influence of an external environment on the quantum chip, it is generally required to package the quantum chip and then run the quantum chip at a low temperature. During the packaging, it is required to electrically connect a signal port of the quantum chip to a transmission line arranged outside the quantum chip. The transmission line is configured to lead out the signal port to implement inputting and outputting the signal. Therefore, performance of the electrical connection between the signal port and the transmission line directly affects signal transmission, and thereby affecting the operation of the quantum chip.

In the related art, the signal port is generally electrically connected to the transmission line by aluminum wire bonding. However, as the quantity of qubits of the quantum chip increases, the quantity of the signal ports on the quantum chip is also increasing. In this case, the quantity of aluminum wires is multiplied due to the manner of connecting the signal port to the above transmission line by aluminum wire bonding, and each aluminum wire will result in impedance and inductive reactance, and thus introduce complex field effect. As a result, the complex field effect leads to unpredictable interference with a transmitted signal on the quantum chip.

### SUMMARY

The present disclosure has a purpose to provide a quantum device, a manufacturing method thereof, and an electronic device, so as to solve the problem in the related art that it may introduce complex field effect and lead to unpredictable interference with a transmitted signal on the quantum chip that the aluminum wire connects the quantum chip to the external transmission line.

An embodiment of the present disclosure provides a quantum device, including: a quantum chip, a package substrate, and a ball grid array.

A signal transmission element and a connecting segment electrically connected to the signal transmission element are formed on the quantum chip.

A lead-out segment and a lead-out signal line configured to be electrically connected to a signal connector are formed on the package substrate, and the lead-out signal line is electrically connected to the lead-out segment.

The ball grid array is configured to electrically connect the connecting segment to the lead-out segment corresponding to each other.

In the quantum device as described above, a surface of the connecting segment in contact with the ball grid array is higher than a surface of the quantum chip.

In the quantum device as described above, the surface of the connecting segment in contact with the ball grid array is a flat plane or an arc-shaped convex surface.

In the quantum device as described above, the signal transmission element is arranged on a first surface of the quantum chip, the connecting segment is arranged on a second surface of the quantum chip opposite to the first surface, a via hole is formed between the first surface and the second surface, and a superconducting metal for electrically connecting the connecting segment to the signal transmission element is formed in the via hole.

In the quantum device as described above, the via hole runs through the connecting segment.

In the quantum device as described above, the connecting segment is made of titanium nitride.

In the quantum device as described above, the quantum chip includes: a first base, a second base, and a superconducting element.

A first segment of the signal transmission element, and a qubit and a read resonant cavity coupled to each other are formed on the first base, and the first segment is coupled to the qubit or the read resonant cavity.

A second segment of the signal transmission element is formed on the second base; and

The superconducting element is configured to electrically connect the first segment to the second segment.

In the quantum device as described above, the superconducting element is made of indium.

In the quantum device as described above, the second base is flipped onto the package substrate, and the first base is flipped onto the second base.

In the quantum device as described above, a plurality of package substrates are provided, and the plurality of package substrates are stacked upon each other, and the lead-out segment of each of the package substrates is electrically connected to the connecting segment corresponding to the lead-out segment.

Another embodiment of the present disclosure provides a manufacturing method for a quantum device, including:
providing a quantum chip;
providing a package substrate; and
forming a ball grid array to electrically connect the connecting segment to the lead-out segment corresponding to the connecting segment.

A signal transmission element and a connecting segment electrically connected to the signal transmission element are formed on the quantum chip.

A lead-out segment and a lead-out signal line configured to be electrically connected to a signal connector are formed on the package substrate, and the lead-out signal line is electrically connected to the lead-out segment

An embodiment of the present disclosure provides an electronic device, including: a package assembly; a signal connector, and the quantum device as described above.

The signal connector is installed on the package assembly. The quantum device is arranged in the package assembly. The lead-out signal line is electrically connected to the signal connector.

Compared with the related art, the quantum device according to the present disclosure includes a quantum chip, a package substrate, and a ball grid array. A signal transmission element and a connecting segment electrically connected to the signal transmission element are formed on the quantum chip. A lead-out segment and a lead-out signal line configured to be electrically connected to a signal connector are formed on the package substrate, and the lead-out signal line is electrically connected to the lead-out segment. The ball grid array electrically connects the connecting segment to the lead-out segment whose signal transmission properties correspond to each other, thereby achieving electrically connecting the quantum chip to the lead-out signal line, and leading out and electrically connecting the connecting segment to an external signal connector. In the present disclosure, the ball grid array does not produce complex field effect, and the electrical connection between the connecting segment and the lead-out segment corresponding to each other by using the ball grid array can prevent the interference of the field effect caused by aluminum wires.

### BRIEF DESCRIPTION OF DRAWINGS

In order to better illustrate the technical solutions in embodiments of the present disclosure, the accompanying drawings used in the description of the embodiments will be briefly introduced below. It is obvious that the accompanying drawings described below are merely some embodiments of the present disclosure, and other drawings can be obtained by one skilled in the art from the provided drawings without any creative effort.
FIG. 1(a) is a schematic structural diagram of a quantum chip in the related art, and FIG. 1(b) is a schematic diagram showing a bonding connection between a transmission line led out by a signal port and a quantum chip.
FIG. 2 is a schematic structural diagram of a package substrate according to an embodiment of the present disclosure.
FIG. 3 is a schematic structural diagram of a quantum device according to an embodiment of the present disclosure.
FIG. 4 is a schematic structural diagram of a quantum device according to another embodiment of the present disclosure.
FIG. 5 is a schematic structural diagram of a first base 17 and a second base 18 of a quantum chip according to an embodiment of the present disclosure.
FIG. 6 is a schematic flowchart of a manufacturing method for a quantum device according to an embodiment of the present disclosure.

### Reference signs:

1: quantum chip, 10: qubit, 11: read resonant cavity, 12: XY transmission line, 13: Z transmission line, 14: read transmission line, 15: connecting segment, 16: via hole;
17: first base, 18: second base, 121: first-segment XY transmission line, 122: second-segment XY transmission line, 131: first-segment Z transmission line, 132: second-segment Z transmission line, 141: first-segment read transmission line, 142: second-segment read transmission line;
2: package substrate, 21: lead-out segment, 22: lead-out signal line, 23: connector joint;
3: ball grid array.

### DESCRIPTION OF EMBODIMENTS

Embodiments described below with reference to the drawings are exemplary, are just intended to explain the present disclosure, and cannot be construed as limiting the present disclosure.

In order to better illustrate the objectives, technical solutions and advantages of the present disclosure, embodiments of the present disclosure will be described in detail below in conjunction with the accompanying drawings. However, one skilled in the art can understand that, in the embodiments of the present disclosure, numerous technical details are proposed in order to enable a reader to better understand the present disclosure. However, the technical solutions claimed in the present disclosure can be implemented without these technical details and various changes and modifications based on the embodiments below. The embodiments below are divided just for the sake of convenience of description, and shall not constitute any limitation on specific implementation manners of the present disclosure. The embodiments can be combined with each other and mutually referenced without contradiction.

It should be noted that the terms "first", "second", or the like, in the specification and claims of the present disclosure and in the foregoing drawings are justfor the purpose of distinguishing between similar objects and not necessarily for describing a particular order or a sequential order. It should be understood that data thus used is interchangeable in proper circumstances, such that the embodiments of the present disclosure described herein can be implemented in orders except those shown or described herein. In addition, the terms "include/comprise" and "have" and any other variants thereof are intended to cover the non-exclusive inclusion. For example, a process, a method, a system, a product, or a device that includes a series of steps or units is not necessarily limited to those expressly listed steps or units, but may include other steps or units not expressly listed or inherent to such a process, a method, a product, or a device.

Further, it should be understood that when a layer (or film), a region, a pattern, or a structure is referred to as being "on" a substrate, a layer (or film), a region, and/or a pattern, it may be directly on another layer or substrate, and/or there may be an insertion layer. Further, it should be understood that when a layer is referred to as being "under" another layer, it may be directly under another layer, and/or there may be one or more insertion layers. Furthermore, reference for "on" and "under" a layer may be made to the drawings.

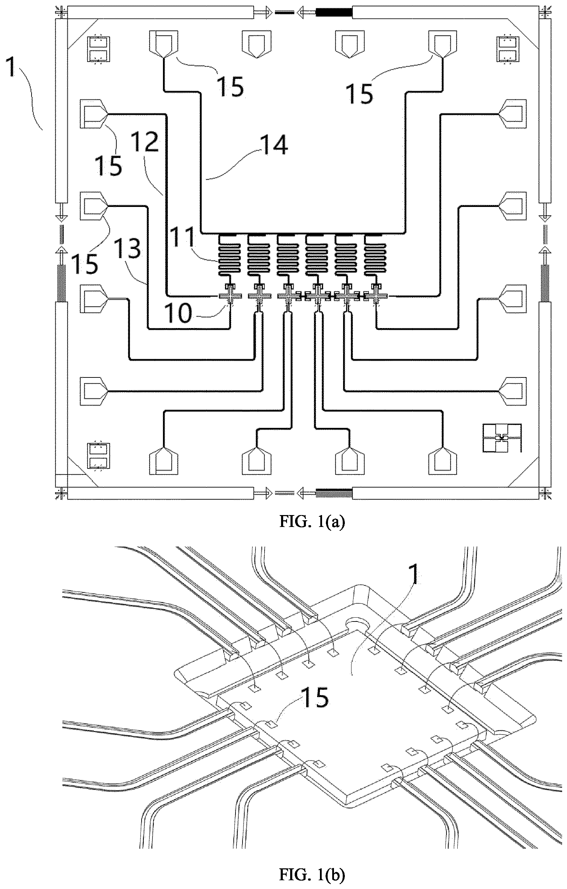

FIG. 1(a) is a schematic structural diagram of a quantum chip in the related art. FIG. 1(b) is a schematic diagram of a bonding connection between a transmission line led out by a signal port and a quantum chip.

Quantum computing is a new computing mode that follows the laws of quantum mechanics to regulate quantum information units for computation. One of the most basic principles of quantum computing is a principle of quantum-mechanical superposition of states. The principle of quantum-mechanical superposition of states enables states of the quantum information units to be in a variety of superposition states, such that quantum information processing has greater potential in terms of efficiency than classical information processing. The quantum chip is a processor that performs quantum computing in a quantum computer. A qubit structure included in the quantum chip is a processing unit of the processor.

A plurality of qubits 10 and read resonant cavities 11 in one-to-one correspondence and coupled to each other are integrated on a quantum chip 1. An end of each of the read resonant cavities 11 away from the qubit corresponding to the read resonant cavity 11 is connected to a read transmission line 14 integrated on the quantum chip. The read transmission line 14 is configured to receive a sounding signal and transmit a feedback signal of the sounding signal. Each qubit 10 is coupled to an XY transmission line 12 and a Z transmission line 13. The XY transmission line 12 is configured to receive a quantum-state regulation signal. The Z transmission line 13 is configured to receive a magnetic flux regulation signal. The magnetic flux regulation signal includes a bias voltage signal and/or a pulse bias regulation signal. Both the bias voltage signal and the pulse bias regulation signal may regulate a frequency of the qubit. The read transmission line 14 is configured to receive a read sounding signal and transmit a read feedback signal. For example, a carrier frequency pulse signal is applied through the read transmission line 14, generally called a read sounding signal. The read sounding signal is generally a microwave signal with a frequency within a range from 4 to 8 GHz, and a quantum state of the qubit is determined by analyzing the read feedback signal outputted by the read transmission line 14.

The XY transmission line 12, the Z transmission line 13, and the read transmission line 14 have a signal port for inputting a signal on an external transmission line and/or outputting a signal on the quantum chip to the external transmission line, for example, a connecting segment 15 as shown in FIG. 1. It should be noted that structures of other functional elements except the connecting segment 15 are not shown in FIG. 1(b). When the transmission line is electrically connected to the signal port on the quantum chip 1 by aluminum bonding wires (wire bonding), the aluminum wire results in increment of inductance on a signal transmission path and the like, thereby affecting signal transmission. As the quantity of qubits increases, the quantity of the signal ports on the quantum chip 1 also increases. The quantity of aluminum wires is multiplied in a structure where the transmission line and the quantum chip are connected through aluminum wire bonding. Each of the aluminum wires will cause impedance and inductive reactance, and thereby introduce complex field effect. In this case, the complex field effect leads to unpredictable interference with a transmitted signal on the quantum chip 1. As a result, a signal transmission mode of the quantum chip in actual operation deviates significantly from an expected signal transmission mode.

An embodiment of the present disclosure providse a quantum device, a manufacturing method thereof, and an electronic device, so as to solve the problem in the related art that it may introduce complex field effect and lead to unpredictable interference with a transmitted signal on the quantum chip that the aluminum wire connects the quantum chip to the external transmission line.

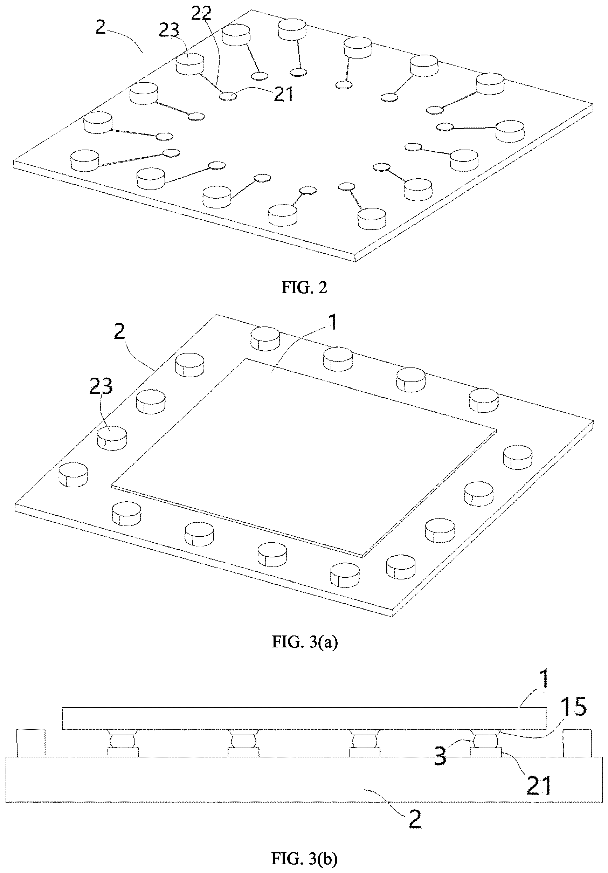

FIG. 2 is a schematic structural diagram of a package substrate 2 according to an embodiment of the present disclosure. FIG. 3 is a schematic structural diagram of a quantum device according to an embodiment of the present disclosure.

Referring to FIG. 2 and FIG. 3, a quantum device provided in some embodiments of the present disclosure includes a quantum chip 1, a package substrate 2, and a ball grid array 3.

A signal transmission element and a connecting segment 15 electrically connected to the signal transmission element are formed on the quantum chip 1. For example, the quantum chip 1 is a superconducting quantum chip. The signal transmission element includes at least one of an XZ transmission line 12 coupled to a qubit 10 on the superconducting quantum chip, a Z transmission line 13 coupled to the qubit 10 on the superconducting quantum chip, and a read transmission line 14 coupled to a read resonant cavity 11 on the superconducting quantum chip. The connecting segment 15 is a metal pattern formed on the quantum chip by coating and deposition. Each XZ transmission line 12, each Z transmission line 13, and each read transmission line 14 are electrically connected to the corresponding connecting segments 15.

A lead-out segment 21 and a lead-out signal line 22 configured to be electrically connected to a signal connector are formed on the package substrate 2, and the lead-out signal line 22 is electrically connected to the lead-out segment 21. In some embodiments of the present disclosure, the package substrate 2 may be a printed circuit board (PCB).

The ball grid array 3 electrically connects the connecting segment 15 and the lead-out segment 21 corresponding to each other. It can be understood that, in the quantum device including the superconducting quantum chip, the ball grid array 3 may include a plurality of solder balls formed by superconducting materials such as tin. That is, the connecting segment 15 and the lead-out segment 21 corresponding to each other are connected by the plurality of solder balls.

Compared with the related art, in the quantum device according to an embodiment of the present disclosure, the ball grid array 3 electrically connects the connecting segment 15 and the lead-out segment 21 whose signal transmission properties correspond to each other. As a result, the quantum chip 1 is electrically connected to the lead-out signal line 22, and the connecting segment 15 is connected to an external signal connector (the signal connector connected to a connector joint 23 is not shown in FIG. 1) through the lead-out signal line 22. Compared with the aluminum wire connection in the related art, in some embodiments of the present disclosure, the ball grid array 3 does not produce complex field effect, and the electrical connection between the connecting segment 15 and the lead-out segment 21 corresponding to each other by using the ball grid array 3 can prevent the complex field effect caused by aluminum wires That is, the interference of the complex field effect with the signal transmission of the quantum chip is prevented. It should be noted that "signal transmission properties correspond to each other" means that it is the same for the quantum chip that signals transmitted by the connecting segment 15 and the lead-out segment 21 electrically connected by the ball grid array 3. For example, if the connecting segment 15 is configured to access the quantum-state regulation signal, the lead-out segment 21 corresponding to the signal transmission property of the connecting segment 15 is configured to transmit the quantum-state regulation signal.

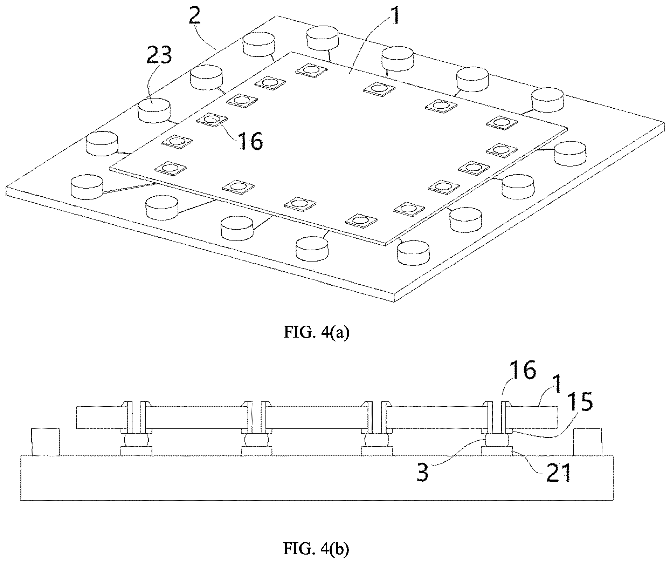

FIG. 4 is a schematic structural diagram of a quantum device according to another embodiment of the present disclosure. Structures of other functional elements except the connecting segment 15 and the via hole 16 are not shown in FIG. 4.

Referring to FIG. 3 and FIG. 4, in some embodiments of the present disclosure, a surface of the connecting segment 15 in contact with the ball grid array 3 is higher than a surface of the quantum chip 1, that is, a surface on a side of the connecting segment 15 away from the quantum chip 1 protrudes outwards relative to the surface of the quantum chip 1 where the connecting segment 15 is arranged, so as to prevent a solder void generated when the surface of the connecting segment 15 in contact with the ball grid array 3 is concave. For example, it is not easy to discharge air on the concave surface during soldering by the solder balls, thereby resulting in accumulation to form the solder void. In an embodiment, the surface of the connecting segment 15 in contact with the ball grid array 3 is a flat plane or an arc-shaped convex surface.

Referring to FIG. 4, in some other embodiments of the present disclosure, the signal transmission element is arranged on a first surface of the quantum chip 1 (see an upper surface of the quantum chip in FIG. 4), the connecting segment 15 is arranged on a second surface of the quantum chip (see a lower surface of the quantum chip in FIG. 4) opposite to the first surface, and a via hole 16 is formed between the first surface and the second surface. A superconducting metal for electrically connecting the connecting segment 15 to the signal transmission element is formed in the via hole 16. That is, patterns of the connecting segment 15 and other functional elements such as the signal transmission element of the quantum chip 1 are located on different surfaces of the quantum chip. In this structural form, a soldering structure of the ball grid array 3 has less influence on the other functional elements such as the signal transmission element on the quantum chip 1. For example, the superconducting metal in the via hole 16 may be a superconducting metal layer attached to an inner wall of the via hole 16 or a superconducting metal column completely filling the via hole 16.

For example, the via hole 16 runs through the connecting segment 15, and the superconducting metal is a superconducting metal layer attached to the inner wall of the via hole 16. The superconducting metal layer in the via hole 16 forms an air discharge channel, which facilitates discharging air during soldering of the solder balls and prevents a solder void formed due to impossible discharge of the air accumulating on a soldering contact surface between the solder ball and the connecting segment 15.

For example, the connecting segment 15 is made of titanium nitride. For example, the connecting segment 15 is a titanium nitride pad formed on the surface of the quantum chip 1. Titanium nitride is easy to adhere, and may be electrically connected to solder balls of a Ball Crid Array (BGA) process without using any intermediate metal.

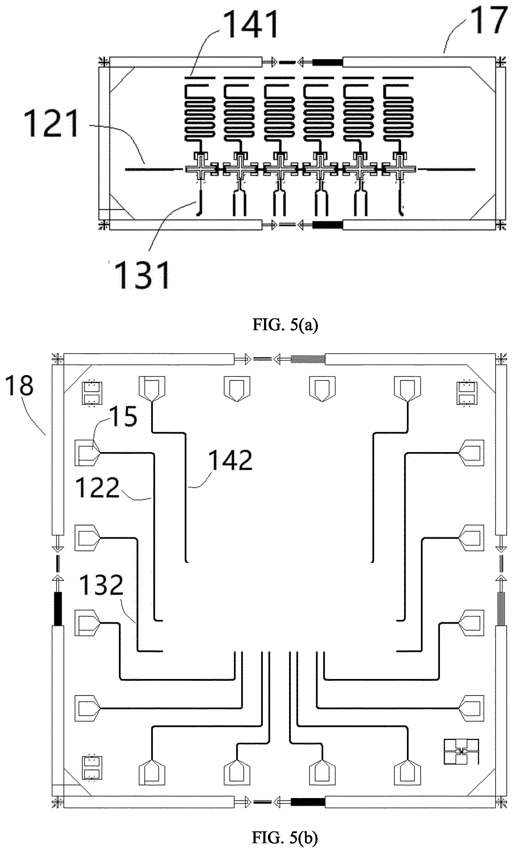

FIG. 5 is a schematic structural diagram of a first base 17 and a second base 18 of a quantum chip according to an embodiment of the present disclosure.

Referring to FIG. 5, in some embodiments of the present disclosure, the quantum chip 1 includes: a first base 17, a second base 18, and a superconducting element.

A first segment of the signal transmission element, and a qubit 10 and a read resonant cavity 11 coupled to each other are formed on the first base 17, and the first segment is coupled to the qubit 10 or the read resonant cavity 11. In some embodiments of the present disclosure, the first segment of the signal transmission element may be, for example, a first-segment XY transmission line 121, a first-segment Z transmission line 131, and a first-segment read transmission line 141.

A second segment of the signal transmission element is formed on the second base 18. In some embodiments of the present disclosure, the second segment of the signal transmission element may be, for example, a second-segment XY transmission line 122, a second-segment Z transmission line 132, and a second-segment read transmission line 142.

The superconducting element electrically connects the first segment to the second segment. For example, the superconducting element electrically connects the first-segment XY transmission line 121 to the second-segment XY transmission line 122, the superconducting element electrically connects the first-segment Z transmission line 131 to the second-segment Z transmission line 132, and the superconducting element electrically connects the first-segment read transmission line 141 to the second-segment read transmission line 142.

In order to prevent influence of a space occupied by intricate wiring on the quantum chip on expansion of the quantity of qubits, in some embodiments of the present disclosure, the signal transmission element is divided into different segments and different segments are arranged on different bases, respectively. When a first segment of the signal transmission element is connected to a second segment of the signal transmission element, a complete graphic structure of the signal transmission element is formed. This structural arrangement allows the base for manufacturing the qubits to leave more space for manufacturing qubit graphic structures, so as to facilitate the expansion of the quantity of qubits. In an embodiment, the superconducting element has a structure formed of any superconducting material. For example, the superconducting element is an indium column.

In some embodiments of the present disclosure, the second base 18 is flipped onto the package substrate 2, and the first base 17 is flipped onto the second base 18. When graphic structures of the connecting segment 15 and the qubit 1 are located on different substrates, the signal transmission element may be led out to the package substrate 2 by flip chip bonding by using solder balls.

In some embodiments of the present disclosure, a plurality of package substrates 2 are provided, the plurality of package substrates 2 are stacked upon each other, and the lead-out segment 21 of each of the package substrates 2 is electrically connected to the connecting segment 15 corresponding to the lead-out segment 21. When there is a larger quantity of qubits, the packaging requires a larger quantity of signal connectors to be connected, and joints of the signal connectors (for example, SMA joints or SMP joints) are generally large in size and require to occupy a certain space. In this case, therefore, the lead-out segments 21 of the plurality of package substrates 2 are electrically connected to the connecting segments 15 corresponding to the lead-out segments 21, such that external signal connectors are easily distributed to the plurality of package substrates 2 to be connected to connector joints 23.

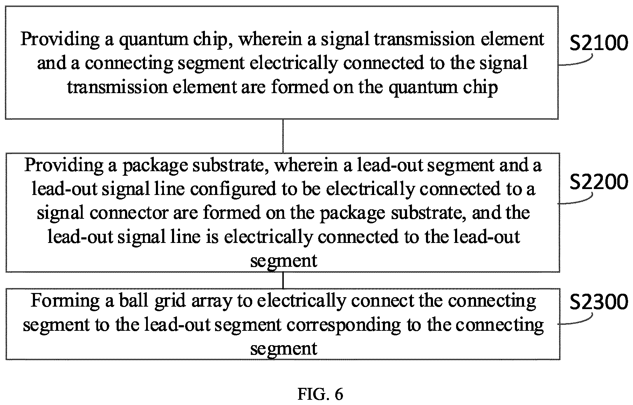

FIG. 6 is a schematic flowchart of a manufacturing method for a quantum device according to some embodiments of the present disclosure.

Referring to FIG. 6, a manufacturing method for a quantum device according to some embodiments of the present disclosure includes: providing a quantum chip 1, providing a package substrate 2, and forming a ball grid array 3.

A signal transmission element and a connecting segment 15 electrically connected to the signal transmission element are formed on the quantum chip 1. For example, the quantum chip 1 is a superconducting quantum chip. The signal transmission element includes at least one of an XZ transmission line 12 coupled to a qubit 10 on the superconducting quantum chip, a Z transmission line 13 coupled to the qubit 10 on the superconducting quantum chip, and a read transmission line 14 coupled to a read resonant cavity 11 on the superconducting quantum chip.

A lead-out segment 21 and a lead-out signal line 22 configured to be electrically connected to a signal connector are formed on the package substrate 2, and the lead-out signal line 22 is electrically connected to the lead-out segment 21. In some embodiments of the present disclosure, the package substrate 2 may be a PCB.

The ball grid array 3 is formed to electrically connect the connecting segment 15 to the lead-out segment 21 corresponding to the connecting segment 15. It can be understood that, in the quantum device including the superconducting quantum chip, the ball grid array 3 may include a plurality of solder balls formed of superconducting materials such as tin. That is, the connecting segment 15 and the lead-out segment 21 corresponding to each other are connected by the plurality of solder balls.

In an embodiment of the present disclosure, the quantum chip 1 is flipped onto the package substrate 2, and the connecting segment 15 is electrically connected to the lead-out segment 21 corresponding to the connecting segment 15 by the formed ball grid array 3.

In another embodiment of the present disclosure, the quantum chip 1 is packaged face-up on the package substrate 2, and the connecting segment 15 is electrically connected to the lead-out segment 21 corresponding to the connecting segment 15 by the formed ball grid array 3. For example, the signal transmission element is formed on a first surface of the quantum chip 1, the connecting segment 15 is formed on a second surface of the quantum chip 1 opposite to the first surface, then a via hole 16 is formed between the first surface and the second surface, and a superconducting metal for electrically connecting the connecting segment 15 to the signal transmission element is formed in the via hole 16. For example, the superconducting metal in the via hole 16 may be a superconducting metal layer attached to an inner wall of the via hole 16 or a superconducting metal column completely filling the via hole 16. In an example, the via hole 16 runs through the connecting segment 15, and the superconducting metal is a superconducting metal layer attached to the inner wall of the via hole 16. The superconducting metal layer in the via hole 16 forms an air discharge channel, which facilitates discharging the air during soldering of the solder balls and prevents a solder void formed due to impossible discharge of the air accumulating on a soldering contact surface between the solder ball and the connecting segment 15. In another example, the connecting segment 15 is made of titanium nitride. For example, the connecting segment 15 is a titanium nitride pad formed on the surface of the quantum chip 1. Titanium nitride is easy to adhere, and may be electrically connected to solder balls of a BGA process without using any intermediate metal.

In some embodiments of the present disclosure, in order to facilitate the expansion of the quantity of qubits, the provided quantum chip 1 includes: a first base 17, a second base 18, and a superconducting element.

A first segment of the signal transmission element, and a qubit 10 and a read resonant cavity 11 coupled to each other are formed on the first base 17, and the first segment is coupled to the qubit 10 or the read resonant cavity 11. In some embodiments of the present disclosure, the first segment of the signal transmission element may be, for example, a first-segment XY transmission line 121, a first-segment Z transmission line 131, and a first-segment read transmission line 141.

A second segment of the signal transmission element is formed on the second base 18. In some embodiments of the present disclosure, the second segment of the signal transmission element may be, for example, a second-segment XY transmission line 122, a second-segment Z transmission line 132, and a second-segment read transmission line 142.

The superconducting element electrically connects the first segment to the second segment. For example, the superconducting element electrically connects the first-segment XY transmission line 121 to the second-segment XY transmission line 122, the superconducting element electrically connects the first-segment Z transmission line 131 to the second-segment Z transmission line 132, and the superconducting element electrically connects the first-segment read transmission line 141 to the second-segment read transmission line 142.

Compared with the related art, in the quantum device manufactured with the manufacturing method according to an embodiments of the present disclosure, the ball grid array 3 electrically connects the connecting segment 15 to the lead-out segment 21 whose signal transmission properties correspond to each other, thereby achieving electrically connecting the quantum chip 1 to the lead-out signal line 22, and leading out the connecting segment 15 to an external signal connector. The ball grid array 3 does not produce complex field effect. Thus, when packaging the quantum chip 1, the electrical connection between the connecting segment 15 and the lead-out segment 21 corresponding to each other by using the ball grid array 3 can prevent interference caused by aluminum wire bonding.

An embodiment of the present disclosure further provides an electronic device, including: a package assembly, a signal connector, and the quantum device in the above embodiments. The signal connector is installed on the package assembly. The quantum device is provided in the package assembly, and the lead-out signal line 22 is electrically connected to the signal connector. For example, the lead-out signal line 22 is electrically connected to the signal connector via a connector joint 23. For example, the package assembly may be a package box, or other structural assemblies that may isolate the quantum device from the external environment.

The structure, features, and effects of the present disclosure have been described in detail with reference to the embodiments shown in the accompanying drawings. The above embodiments are just preferred embodiments of the present disclosure, but the implementation scope of the present disclosure is not limited to the accompanying drawings as shown. Any changes made according to the concept of the present disclosure, or equivalent embodiments that are modified to equivalent variations, shall fall within the protection scope of the present disclosure when they do not go beyond the spirit covered by the specification and the drawings.

## Claims

1. A quantum device, comprising:
a quantum chip, wherein a signal transmission element and a connecting segment electrically connected to the signal transmission element are formed on the quantum chip;
a package substrate, wherein a lead-out segment and a lead-out signal line configured to be electrically connected to a signal connector are formed on the package substrate, and the lead-out signal line is electrically connected to the lead-out segment; and
a ball grid array configured to electrically connect the connecting segment to the lead-out segment corresponding to each other.

2. The quantum device according to claim 1, wherein a surface of the connecting segment in contact with the ball grid array is higher than a surface of the quantum chip.

3. The quantum device according to claim 2, wherein the surface of the connecting segment in contact with the ball grid array is a flat plane or an arc-shaped convex surface.

4. The quantum device according to any one of claims 1-3, wherein the signal transmission element is arranged on a first surface of the quantum chip, the connecting segment is arranged on a second surface of the quantum chip opposite to the first surface, a via hole is formed between the first surface and the second surface, and a superconducting metal for electrically connecting the connecting segment to the signal transmission element is formed in the via hole.

5. The quantum device according to claim 4, wherein the via hole runs through the connecting segment.

6. The quantum device according to claim 4, wherein the connecting segment is made of titanium nitride.

7. The quantum device according to claim 1, wherein the quantum chip comprises:
a first base, wherein a first segment of the signal transmission element, and a qubit and a read resonant cavity coupled to each other are formed on the first base, and the first segment is coupled to the qubit or the read resonant cavity;
a second base, wherein a second segment of the signal transmission element is formed on the second base; and
a superconducting element configured to electrically connecting the first segment to the second segment.

8. The quantum device according to claim 7, wherein the superconducting element is made of indium.

9. The quantum device according to claim 7, wherein the second base is flipped onto the package substrate, and the first base is flipped onto the second base.

10. The quantum device according to claim 1, wherein a plurality of package substrates are provided, and wherein the plurality of package substrates are stacked upon each other, and the lead-out segment of each of the package substrates is electrically connected to the connecting segment corresponding to the lead-out segment.

11. A manufacturing method for a quantum device, comprising:
providing a quantum chip, wherein a signal transmission element and a connecting segment electrically connected to the signal transmission element are formed on the quantum chip;
providing a package substrate, wherein a lead-out segment and a lead-out signal line configured to be electrically connected to a signal connector are formed on the package substrate, and the lead-out signal line is electrically connected to the lead-out segment; and
forming a ball grid array to electrically connect the connecting segment to the lead-out segment corresponding to the connecting segment.

12. An electronic device, comprising:
a package assembly;
a signal connector, wherein the signal connector is installed on the package assembly; and
the quantum device according to any one of claims 1-10, wherein the quantum device is provided in the package assembly, and the lead-out signal line is electrically connected to the signal connector.
